# EUROPEAN PATENT SPECIFICATION

(11) **EP 4 357 114 B1**
(45) Date of publication and mention of the grant of the patent: **14.10.2026**
(21) Application number: 23205008.8
(22) Date of filing: 20.10.2023
(51) Int. Cl.: B29C 70/48, C04B 35/573, C04B 35/80, C04B 35/83, C23C 16/04, F01D 5/28, C04B 41/45, C23C 16/455, C23C 16/458, B29C 33/30, B29C 33/38, C04B 35/571, C04B 35/622, C04B 41/87

(54) **FLOATING TOOLING ASSEMBLY FOR CHEMICAL VAPOR INFILTRATION**
SCHWIMMENDE WERKZEUGANORDNUNG ZUR CHEMISCHEN DAMPFINFILTRATION
ENSEMBLE OUTILLAGE FLOTTANT POUR INFILTRATION CHIMIQUE EN PHASE VAPEUR

(30) Priority: 21.10.2022 US 202217970990
(43) Date of publication of application: 24.04.2024
(73) Proprietor: RTX Corporation, Farmington, CT 06032 (US)
(72) Inventor: BURDETTE, Alyson T., East Hartford, 06118 (US); SURACE, Raymond, East Hartford, 06118 (US); SOBANSKI, Jon Erik, East Hartford, 06118 (US)
(74) Representative: Dehns

(56) References cited:
- CN-A- 107 266 099
- CN-A- 114 105 663
- CN-B- 110 722 718
- FR-A1- 3 021 671
- US-B1- 7 892 646
- US-B2- 10 906 842

## Description

### BACKGROUND

The present invention relates to chemical vapor infiltration (CVI), and more particularly to improved tooling for CVI.

Ceramic matrix composite (CMC) parts are widely fabricated by densifying preforms made from woven fabrics or oriented/braided fiber tows. CVI is a commonly used densification technique practiced in industry. To keep the preforms in a rigid form and maintain proper shape and geometry, perforated tooling can be used to hold the preforms during the initial densification cycle(s). Holes in the tooling allow vaporous precursors to infiltrate into the preform for the deposition of a ceramic matrix. Tooling for simple preform shapes can be designed with uniform hole lengths. When used with complexly-shaped preforms such as turbine airfoils, such holes can be too long to allow vaporous precursors to sufficiently infiltrate the preform at certain locations. Thus, a need exists for improved tooling.

CN 107 266 099 A discloses a prior art tooling assembly as set forth in the preamble of claim 1.

### SUMMARY

From one aspect, there is provided a tooling assembly suitable for use in infiltrating a fibrous preform as recited in claim 1

There is also provided a method of arranging a fibrous preform in a tooling assembly for chemical vapor infiltration (CVI) as recited in claim 13.

Features of embodiments are set forth in the dependent claims.

### BRIEF DESCRIPTION OF THE DRAWINGS

FIG. 1 is a perspective view of a tooling assembly, including an inner fixture and an outer fixture.
FIG. 2 is a cross-sectional view of the tooling assembly taken along line 2-2 of FIG. 1.
FIG. 3 is a simplified cross-sectional view of a mandrel-mounted preform contained within the inner fixture, taken along line 3-3 of FIG. 2.

While the above-identified figures set forth one or more embodiments of the present disclosure, other embodiments are also contemplated, as noted in the discussion. In all cases, this disclosure presents the invention by way of representation and not limitation. It should be understood that numerous other modifications and embodiments can be devised by those skilled in the art, which fall within the scope of the invention. The figures may not be drawn to scale, and applications and embodiments of the present invention may include features and components not specifically shown in the drawings.

### DETAILED DESCRIPTION

This disclosure presents a multipiece tooling assembly for CVI. The assembly includes inner tooling conformal to the perform geometry such that the preform surface is uniformly offset from the external environment. The inner tooling can be placed within outer tooling for support during CVI. The outer tooling design includes large windows that minimally obstruct the inner tooling from the flow of vaporous precursors.

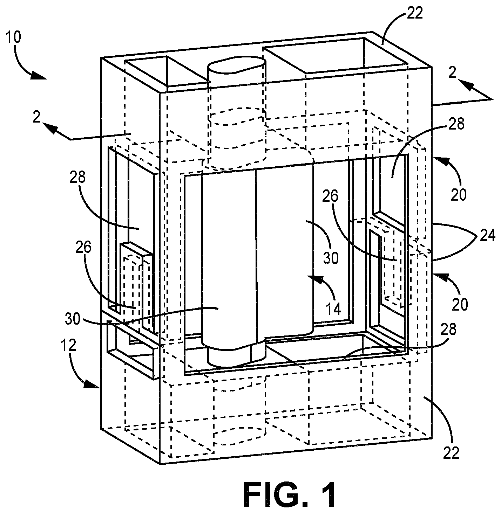

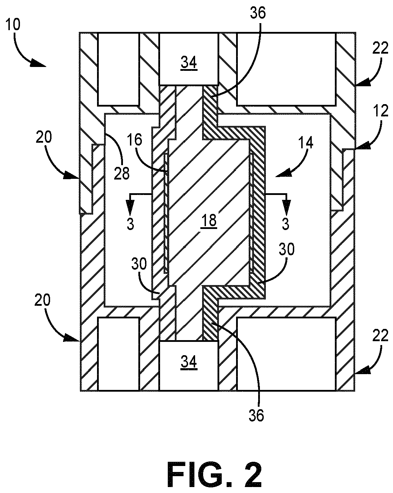

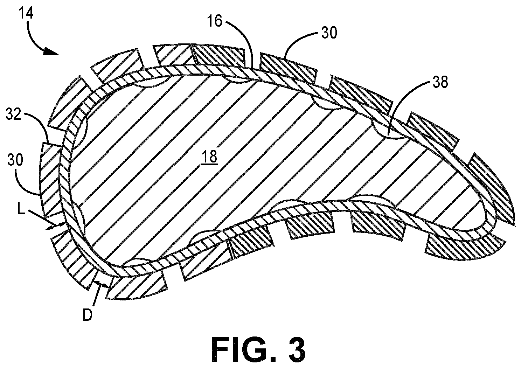

FIG. 1 is a perspective view of tooling assembly 10. FIG 2 is a cross-sectional view of tooling assembly 10 taken along line 2-2 of FIG. 1. FIG. 3 is a simplified cross-sectional view of inner tooling fixture 14, taken along line 3-3 of FIG. 2. FIGS. 1-3 are discussed together.

Tooling assembly 10 includes outer tooling fixture 12 and inner tooling fixture 14. Inner tooling fixture 14 can at least partially surround and helps maintain the shape of fibrous preform 16 (FIGS. 2 and 3), which, as best seen in FIG. 3, includes an airfoil (e.g., of a blade or vane), and can include an inner diameter (ID) and/or outer diameter (OD) platform in some embodiments. In an alternative embodiment, preform 16 can have an alternative (e.g., planar) geometry. In an exemplary embodiment, preform 16 can be formed from tows of silicon carbide (SiC) fibers arranged in one of various two or three-dimensional woven architectures such as plain, harness (e.g., 3, 5, 8, etc.), twill, braid, or non-symmetric to name a few non-limiting examples. In an alternative embodiment, preform 16 can be formed from non-woven (e.g., chopped, felted, etc.) fibers. Preform 16 is mounted on and supported by mandrel 18, although a mandrel need not be used for all types of preforms. Each of outer tooling fixture 12, inner tooling fixture 14, and mandrel 18 can be formed from graphite in an exemplary embodiment. Portions of outer tooling fixture 12 and/or inner tooling fixture 14 can additionally and/or alternatively be formed from refractory metal alloys, non-graphitic forms of carbon (e.g., carbon-carbon composites) and/or ceramics (e.g., SiC). Such features can include, for example, locating pins.

Outer tooling fixture 12 can be formed from multiple portions, which as shown in FIGS. 1 and 2, are generally u-shaped upper and lower portions (or halves) 20. In the embodiment shown in the figures, each of upper and lower portion 20 includes base 22 and oppositely disposed arms/sides 24 extending away from base 20. Upper and lower portions 20 can be removably attached to one another by tabs 26, one tab 26 shown on an arm 24 of each upper and lower portions 20, which are engageable with corresponding slots (not visible in the figures) in arms 24 of lower and upper portions 20, respectively. In an alternative embodiment, tabs 26 can be on just one of upper or lower portions 20, or other connecting/interlocking means, such as one or more pins disposed similarly to tabs 26, or clips and wedges can be used. In yet another alternative embodiment, one of upper or lower portion 20 can include base 22 and arms 24, and the other of upper or lower portion 20 can include just base 22. Other features and shapes for outer tooling fixture 12 are contemplated herein.

Outer tooling fixture 12 can have an overall cuboidal geometry with bases 22 and arms 24 being flat to facilitate placement of tooling assembly 10 into a CVI reactor or on a benchtop during assembly. Outer tooling fixture 12 can further include variously sized windows 28 on each of its sides, with some relatively smaller (i.e., in area) windows 28 on arms 24, and some relatively larger windows 28 orthogonally positioned relative to smaller windows 28 of arms 24, and defined by both upper and lower portions 20 when assembled. Similarly sized (i.e., larger or smaller) windows 28 can be oppositely disposed from one another in an exemplary embodiment. The arrangement with bases 22, arms 24, and windows 28 ensures that outer tooling fixture 12 can adequately support inner tooling fixture 14 while the flow of vaporous precursors can reach inner tooling fixture 14 with minimal obstruction from outer tooling fixture 12.

Inner tooling fixture 14 can also include multiple portions, with two portions 30 shown in FIGS. 1-3 defining the body of inner tooling fixture 14. Although shown in FIGS. 2 and 3 with different hatching to facilitate visualization of individual portions 30, both can be formed from the same material. Portions 30 can be assembled to define a body with one or more curved segments corresponding to airfoil-shaped preform 16. In an alternative embodiment, the body of inner tooling fixture 14 can be defined by a single portion 30 or more than two portions 30 depending, for example, on the complexity of the preform geometry. Inner tooling fixture 14 further includes infiltration holes 32 (FIG. 3) disposed throughout inner tooling fixture 14 and extending through a thickness the respective portion 30. Holes 32 can be positioned to align with one or more of the leading and trailing edges of airfoil-shaped preform 16, as well as the pressure and suction sides and gaspath endwall/platform surfaces. Holes 32 can further be disposed along inner tooling fixture 14 in the longitudinal (i.e., spanwise) direction. Holes 32 place preform 16 in flow communication with the internal volume of the CVI reactor and allow vaporous precursors to reach an infiltrate preform 16.

To facilitate a more even distribution and infiltration of vaporous precursors throughout preform 16, inner tooling fixture 14 is conformal to the curvature of preform 16 such that a depth, or length L of each hole 32 is generally the same throughout internal tooling fixture 14. Accordingly, preform 16 is uniformly offset from the environment (i.e., internal volume of the CVI reactor) with a substantially uniform path length (i.e., L) for the vaporous precursors through internal tooling fixture 14. Each hole 32 also has a diameter D. Furthermore, each hole 32 is generally normal to the surface of preform 16 such that the flow of vaporous precursors through each hole 32 is also normal to the surface of preform 16. Although holes 32 are shown with a generally cylindrical cross-sectional geometry, alternative geometries (e.g., frustoconical) are contemplated herein.

Inner tooling fixture 14 can be mounted within outer tooling fixture 12 via floating attachment. More specifically, each base 22 of outer tooling fixture 12 includes recesses 34 (FIG. 2) for receiving a corresponding neck region 36 (FIG. 2) on opposite ends of inner tooling fixture 14. Optimally, no portion of preform 16 extends into neck region 36. With this arrangement, inner tooling fixture 14 is minimally engaged with, but still adequately supported by outer tooling fixture 12. Recesses 34 can be open such to place inner tooling fixture 12 in flow communication with the environment (e.g., internal volume of the CVI reactor).

Mandrel 18 can include grooves 38 along its outer surface (i.e., the surface in communication with preform 16. Grooves 38 can act as a flow path for vaporous precursors along the inner (i.e., mandrel-facing) surface of preform 16. Such a flow can, for example, access mandrel 18 from recesses 34 of outer tooling fixture 12.

To use tooling assembly 10 for CVI, preform 16 can be laid up around mandrel 18, and portions 30 of inner tooling fixture 14 assembled over preform 16. The lower neck region 36 of inner tooling fixture 14 can be inserted into the corresponding recess 34 of base 22 of lower portion 20. The upper neck region 36 can then be inserted into the corresponding recess 34 of base 22 of upper portion 20, and tabs 26 inserted into the corresponding slots to secure upper portion 20 to lower portion 20, and internal tooling fixture 14 within outer tooling fixture 12. Once secured, tooling assembly 10 can be placed into the CVI reactor and exposed to the flow of vaporous precursors.

Tooling assembly 10 can be used when infiltrating preform 16, via CVI, to deposit interface coatings (e.g., layers of BN, SiC, Si-doped BN, etc.) and/or to form a matrix (e.g., SiC) to create a CMC part. Such CMC parts can be incorporated into aerospace, maritime, or industrial equipment, to name a few, non-limiting examples.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A tooling assembly (10) suitable for use in infiltrating a fibrous preform (16), the tooling assembly (10) comprising:
an outer tooling fixture (12) comprising:
a first portion (20);
a second portion (20), wherein the first portion (20) is removably attached to the second portion (20), each of the first portion (20) and the second portion (20) comprising a base (22) with a recess (34); and
a first pair of oppositely disposed windows (28) defined by the first portion (20) and the second portion (20); and
an inner tooling fixture (14) comprising:
a body defined by at least one portion (30), the body configured to at least partially surround the fibrous preform (16);
a plurality of holes (32) extending through a thickness of the at least one portion (30), each hole (32) of the plurality of holes (32) having a length (L) and a diameter (D); and
a first neck region (36) engageable with the recess (34) of the first portion (20) or the second portion (20),
wherein the first portion (20) of the outer tooling fixture (12) further comprises a first pair of oppositely disposed arms (24) extending away from the base (22),
wherein the second portion (20) of the outer tooling fixture (12) further comprises a second pair of oppositely disposed arms (24) extending away from the base (22),
**characterised in that**
the first portion (20) of the outer tooling fixture (12) further comprises a second pair of oppositely disposed windows (28), wherein one window (28) of the second pair of windows (28) is disposed within one arm (24) of the first pair of arms (24), and wherein the other window (28) of the second pair of windows (28) is disposed within the other arm (24) of the first pair of arms (24).

2. The assembly of claim 1, wherein each of the inner tooling fixture (14) and the outer tooling fixture (12) is formed from graphite.

3. The assembly of claim 1 or 2, wherein:
one arm (24) of the first pair of arms (24) comprises a tab (26); and
a corresponding arm (24) of the second pair of arms (24) comprises a slot for receiving the tab (26).

4. The assembly of any preceding claim, wherein the first pair of windows (28) is disposed orthogonally to the second pair of windows (28).

5. The assembly of any preceding claim, wherein each window (28) of the first pair of windows (28) is larger than each window (28) of the second pair of windows (28).

6. The assembly of any preceding claim, wherein:
the first neck region (36) is engageable with the recess (34) in the base (22) of the first portion (20) of the outer tooling fixture (12); and
the inner tooling fixture (14) further comprises a second neck region (36) engageable with the recess (34) in the base (22) of the second portion (20) of the outer tooling fixture (12).

7. The assembly of any preceding claim, wherein the at least one portion (20) comprises a first portion (20) and a second portion (20), and wherein the body is curved.

8. The assembly of any preceding claim, wherein the body corresponds to a shape of the fibrous preform (16), and wherein the fibrous preform (16) comprises an airfoil.

9. The assembly of any preceding claim and further comprising: a mandrel (18) supporting the fibrous preform (16).

10. The assembly of any preceding claim, wherein the fibrous preform (16) further comprises at least one platform.

11. The assembly of any preceding claim, wherein each hole (32) of the plurality of holes (32) is oriented normal to a surface of the preform (16).

12. The assembly of any preceding claim wherein each hole (32) of the plurality of holes (32) has a cylindrical cross-sectional geometry.

13. A method of arranging a fibrous preform (16) in a tooling assembly (10) for chemical vapor infiltration (CVI), the method comprising:
assembling an inner tooling fixture (14) around the fibrous preform (16);
inserting a first neck region (36) of the inner tooling fixture (14) to a recess (34) in a first portion (20) of an outer tooling fixture (12);
inserting a second neck region (36) of the inner tooling fixture (14) to a recess (34) in a second portion (20) of the outer tooling fixture (12); and
securing the first portion (20) of the outer tooling fixture (12) to the second portion (20) of the outer tooling fixture (14) so as to define a first pair of oppositely disposed windows (28),
wherein the first portion (20) of the outer tooling fixture (12) comprises a first pair of oppositely disposed arms (24) extending away from a base (22) of the first portion (20),
wherein the second portion (20) of the outer tooling fixture (12) comprises a second pair of oppositely disposed arms (24) extending away from a base (22) of the second portion,
**characterised in that**
the first portion (20) of the outer tooling fixture (12) further comprises a second pair of oppositely disposed windows (28), wherein one window (28) of the second pair of windows (28) is disposed within one arm (24) of the first pair of arms (24), and wherein the other window (28) of the second pair of windows (28) is disposed within the other arm (24) of the first pair of arms (24).

14. The method of claim 13, wherein securing the first portion (20) to the second portion (20) comprises inserting a tab (26) or a pin in the first portion (20) into a slot in the second portion (20).

15. The method of claim 13 or 14, wherein the method further comprises laying-up the fibrous preform (16) around a mandrel (18) prior to the step of assembling the inner tooling fixture (14) around the fibrous preform (16).

## Patentansprüche

1. Werkzeugbaugruppe (10), die zur Verwendung beim Infiltrieren eines faserigen Vorformlings (16) geeignet ist, die Werkzeugbaugruppe (10) umfassend:
eine äußere Werkzeugvorrichtung (12), umfassend:
einen ersten Abschnitt (20);
einen zweiten Abschnitt (20), wobei der erste Abschnitt (20) abnehmbar an dem zweiten Abschnitt (20) befestigt ist, jeder von dem ersten Abschnitt (20) und dem zweiten Abschnitt (20) umfassend eine Basis (22) mit einer Aussparung (34); und
ein erstes Paar von einander gegenüberliegend angeordneten Fenstern (28), die durch den ersten Abschnitt (20) und den zweiten Abschnitt (20) definiert sind; und
eine innere Werkzeugvorrichtung (14), umfassend:
einen Körper, der durch mindestens einen Abschnitt (30) definiert ist, wobei der Körper ausgelegt ist, um den faserigen Vorformling (16) mindestens teilweise zu umgeben;
eine Vielzahl von Löchern (32), die sich durch eine Dicke des mindestens einen Abschnitts (30) erstrecken, jedes Loch (32) der Vielzahl von Löchern (32) aufweisend eine Länge (L) und einen Durchmesser (D); und
einen ersten Halsbereich (36), der mit der Aussparung (34) des ersten Abschnitts (20) oder des zweiten Abschnitts (20) in Eingriff bringbar ist,
wobei der erste Abschnitt (20) der äußeren Werkzeugvorrichtung (12) ferner ein erstes Paar von einander gegenüberliegend angeordneten Armen (24) umfasst, die sich von der Basis (22) weg erstrecken,
wobei der zweite Abschnitt (20) der äußeren Werkzeugvorrichtung (12) ferner ein zweites Paar von einander gegenüberliegend angeordneten Armen (24) umfasst, die sich von der Basis (22) weg erstrecken,
**dadurch gekennzeichnet, dass**
der erste Abschnitt (20) der äußeren Werkzeugvorrichtung (12) ferner ein zweites Paar von einander gegenüberliegend angeordneten Fenstern (28) umfasst, wobei ein Fenster (28) des zweiten Paares von Fenstern (28) innerhalb eines Armes (24) des ersten Paares von Armen (24) angeordnet ist und wobei das andere Fenster (28) des zweiten Paares von Fenstern (28) innerhalb des anderen Armes (24) des ersten Paares von Armen (24) angeordnet ist.

2. Baugruppe nach Anspruch 1, wobei jede von der inneren Werkzeugvorrichtung (14) und der äußeren Werkzeugvorrichtung (12) aus Graphit ausgebildet ist.

3. Baugruppe nach Anspruch 1 oder 2, wobei:
ein Arm (24) des ersten Paares von Armen (24) eine Lasche (26) umfasst; und
ein entsprechender Arm (24) des zweiten Paares von Armen (24) einen Schlitz zum Aufnehmen der Lasche (26) umfasst.

4. Baugruppe nach einem der vorhergehenden Ansprüche, wobei das erste Paar von Fenstern (28) orthogonal zu dem zweiten Paar von Fenstern (28) angeordnet ist.

5. Baugruppe nach einem der vorhergehenden Ansprüche, wobei jedes Fenster (28) des ersten Paares von Fenstern (28) größer als jedes Fenster (28) des zweiten Paares von Fenstern (28) ist.

6. Baugruppe nach einem der vorhergehenden Ansprüche, wobei:
der erste Halsbereich (36) mit der Aussparung (34) in der Basis (22) des ersten Abschnitts (20) der äußeren Werkzeugvorrichtung (12) in Eingriff bringbar ist; und
die innere Werkzeugvorrichtung (14) ferner einen zweiten Halsbereich (36) umfasst, der mit der Aussparung (34) in der Basis (22) des zweiten Abschnitts (20) der äußeren Werkzeugvorrichtung (12) in Eingriff bringbar ist.

7. Baugruppe nach einem der vorhergehenden Ansprüche, wobei der mindestens eine Abschnitt (20) einen ersten Abschnitt (20) und einen zweiten Abschnitt (20) umfasst und wobei der Körper gekrümmt ist.

8. Baugruppe nach einem der vorhergehenden Ansprüche, wobei der Körper einer Form des faserigen Vorformlings (16) entspricht und wobei der faserige Vorformling (16) ein Schaufelblatt umfasst.

9. Baugruppe nach einem der vorhergehenden Ansprüche, ferner umfassend: einen Dorn (18), der den faserigen Vorformling (16) stützt.

10. Baugruppe nach einem der vorhergehenden Ansprüche, wobei der faserige Vorformling (16) ferner mindestens eine Plattform umfasst.

11. Baugruppe nach einem der vorhergehenden Ansprüche, wobei jedes Loch (32) der Vielzahl von Löchern (32) senkrecht zu einer Oberfläche des Vorformlings (16) ausgerichtet ist.

12. Baugruppe nach einem der vorhergehenden Ansprüche, wobei jedes Loch (32) der Vielzahl von Löchern (32) eine zylindrische Querschnittsgeometrie aufweist.

13. Verfahren zum Anordnen eines faserigen Vorformlings (16) in einer Werkzeugbaugruppe (10) zur chemischen Dampfinfiltration (CVI), das Verfahren umfassend:
Montieren einer inneren Werkzeugvorrichtung (14) um den faserigen Vorformling (16);
Einsetzen eines ersten Halsabschnitts (36) der inneren Werkzeugvorrichtung (14) in eine Aussparung (34) in einem ersten Abschnitt (20) einer äußeren Werkzeugvorrichtung (12);
Einsetzen eines zweiten Halsbereichs (36) der inneren Werkzeugvorrichtung (14) in eine Aussparung (34) in einem zweiten Abschnitt (20) der äußeren Werkzeugvorrichtung (12); und
Sichern des ersten Abschnitts (20) der äußeren Werkzeugvorrichtung (12) an dem zweiten Abschnitt (20) der äußeren Werkzeugvorrichtung (14) so, dass ein erstes Paar von einander gegenüberliegend angeordneten Fenstern (28) definiert wird,
wobei der erste Abschnitt (20) der äußeren Werkzeugvorrichtung (12) ein erstes Paar von einander gegenüberliegend angeordneten Armen (24) umfasst, die sich von der Basis (22) des ersten Abschnitts (20) weg erstrecken,
wobei der zweite Abschnitt (20) der äußeren Werkzeugvorrichtung (12) ein zweites Paar von einander gegenüberliegend angeordneten Armen (24) umfasst, die sich von der Basis (22) des zweiten Abschnitts weg erstrecken,
**dadurch gekennzeichnet, dass**
der erste Abschnitt (20) der äußeren Werkzeugvorrichtung (12) ferner ein zweites Paar von einander gegenüberliegend angeordneten Fenstern (28) umfasst, wobei ein Fenster (28) des zweiten Paares von Fenstern (28) innerhalb eines Armes (24) des ersten Paares von Armen (24) angeordnet ist und wobei das andere Fenster (28) des zweiten Paares von Fenstern (28) innerhalb des anderen Armes (24) des ersten Paares von Armen (24) angeordnet ist.

14. Verfahren nach Anspruch 13, wobei das Sichern des ersten Abschnitts (20) an dem zweiten Abschnitt (20) ein Einsetzen einer Lasche (26) oder eines Stiftes in dem ersten Abschnitt (20) in einen Schlitz in dem zweiten Abschnitt (20) umfasst.

15. Verfahren nach Anspruch 13 oder 14, wobei das Verfahren vor dem Schritt des Montierens der inneren Werkzeugvorrichtung (14) um den faserigen Vorformling (16) ferner ein Aufschichten des faserigen Vorformlings (16) um einen Dorn (18) umfasst.

## Revendications

1. Ensemble d'outillage (10) approprié pour une utilisation dans l'infiltration d'une préforme fibreuse (16), l'ensemble d'outillage (10) comprenant :
un élément d'outillage extérieur (12) comprenant :
une première partie (20) ;
une deuxième partie (20), dans lequel la première partie (20) est fixée de manière amovible à la deuxième partie (20), chacune de la première partie (20) et de la deuxième partie (20) comprenant une base (22) avec un évidement (34) ; et
une première paire de fenêtres opposées (28) définie par la première partie (20) et la deuxième partie (20) ; et
un élément d'outillage intérieur (14) comprenant :
un corps défini par au moins une partie (30), le corps étant configuré pour entourer au moins partiellement la préforme fibreuse (16) ;
une pluralité de trous (32) s'étendant à travers une épaisseur de l'au moins une partie (30), chaque trou (32) de la pluralité de trous (32) ayant une longueur (L) et un diamètre (D) ; et
une première région de col (36) pouvant venir en prise avec l'évidement (34) de la première partie (20) ou de la deuxième partie (20),
dans lequel la première partie (20) de l'élément d'outillage extérieur (12) comprend en outre une première paire de bras opposés (24) s'étendant à distance de la base (22),
dans lequel la deuxième partie (20) de l'élément d'outillage extérieur (12) comprend en outre une deuxième paire de bras opposés (24) s'étendant à distance de la base (22),
**caractérisé en ce que**
la première partie (20) de l'élément d'outillage extérieur (12) comprend en outre une deuxième paire de fenêtres opposées (28), dans lequel une fenêtre (28) de la deuxième paire de fenêtres (28) est disposée dans un bras (24) de la première paire de bras (24), et dans lequel l'autre fenêtre (28) de la deuxième paire de fenêtres (28) est disposée dans l'autre bras (24) de la première paire de bras (24).

2. Ensemble selon la revendication 1, dans lequel chacun de l'élément d'outillage intérieur (14) et de l'élément d'outillage extérieur (12) est formé en graphite.

3. Ensemble selon la revendication 1 ou 2, dans lequel :
un bras (24) de la première paire de bras (24) comprend une languette (26) ; et
un bras correspondant (24) de la deuxième paire de bras (24) comprend une fente pour recevoir la languette (26).

4. Ensemble selon l'une quelconque des revendications précédentes, dans lequel la première paire de fenêtres (28) est disposée orthogonalement à la deuxième paire de fenêtres (28).

5. Ensemble selon l'une quelconque des revendications précédentes, dans lequel chaque fenêtre (28) de la première paire de fenêtres (28) est plus grande que chaque fenêtre (28) de la deuxième paire de fenêtres (28).

6. Ensemble selon l'une quelconque des revendications précédentes, dans lequel :
la première région de col (36) peut venir en prise avec l'évidement (34) dans la base (22) de la première partie (20) de l'élément d'outillage extérieur (12) ; et
l'élément d'outillage intérieur (14) comprend en outre une deuxième région de col (36) pouvant venir en prise avec l'évidement (34) dans la base (22) de la deuxième partie (20) de l'élément d'outillage extérieur (12).

7. Ensemble selon l'une quelconque des revendications précédentes, dans lequel l'au moins une partie (20) comprend une première partie (20) et une deuxième partie (20), et dans lequel le corps est incurvé.

8. Ensemble selon l'une quelconque des revendications précédentes, dans lequel le corps correspond à une forme de la préforme fibreuse (16), et dans lequel la préforme fibreuse (16) comprend un profil aérodynamique.

9. Ensemble selon l'une quelconque des revendications précédentes et comprenant en outre : un mandrin (18) supportant la préforme fibreuse (16).

10. Ensemble selon l'une quelconque des revendications précédentes, dans lequel la préforme fibreuse (16) comprend en outre au moins une plateforme.

11. Ensemble selon l'une quelconque des revendications précédentes, dans lequel chaque trou (32) de la pluralité de trous (32) est orienté normalement à une surface de la préforme (16).

12. Ensemble selon l'une quelconque des revendications précédentes dans lequel chaque trou (32) de la pluralité de trous (32) a une géométrie de section transversale cylindrique.

13. Procédé d'agencement d'une préforme fibreuse (16) dans un ensemble d'outillage (10) pour une infiltration chimique en phase vapeur (CVI), le procédé comprenant :
l'assemblage d'un élément d'outillage intérieur (14) autour de la préforme fibreuse (16) ;
l'insertion d'une première région de col (36) de l'élément d'outillage intérieur (14) dans un évidement (34) dans une première partie (20) d'un élément d'outillage extérieur (12) ;
l'insertion d'une deuxième région de col (36) de l'élément d'outillage intérieur (14) dans un évidement (34) dans une deuxième partie (20) de l'élément d'outillage extérieur (12) ; et
la fixation de la première partie (20) de l'élément d'outillage extérieur (12) à la deuxième partie (20) de l'élément d'outillage extérieur (14) de manière à définir une première paire de fenêtres opposées (28),
dans lequel la première partie (20) de l'élément d'outillage extérieur (12) comprend une première paire de bras opposés (24) s'étendant à distance d'une base (22) de la première partie (20),
dans lequel la deuxième partie (20) de l'élément d'outillage extérieur (12) comprend une deuxième paire de bras opposés (24) s'étendant à distance d'une base (22) de la deuxième partie,
**caractérisé en ce que**
la première partie (20) de l'élément d'outillage extérieur (12) comprend en outre une deuxième paire de fenêtres opposées (28), dans lequel une fenêtre (28) de la deuxième paire de fenêtres (28) est disposée dans un bras (24) de la première paire de bras (24), et dans lequel l'autre fenêtre (28) de la deuxième paire de fenêtres (28) est disposée dans l'autre bras (24) de la première paire de bras (24).

14. Procédé selon la revendication 13, dans lequel la fixation de la première partie (20) à la deuxième partie (20) comprend l'insertion d'une languette (26) ou d'une broche dans la première partie (20) dans une fente dans la deuxième partie (20).

15. Procédé selon la revendication 13 ou 14, dans lequel le procédé comprend en outre le drapage de la préforme fibreuse (16) autour d'un mandrin (18) avant l'étape d'assemblage de l'élément d'outillage intérieur (14) autour de la préforme fibreuse (16).
